# EUROPEAN PATENT SPECIFICATION

(11) **EP 3 561 148 B1**
(45) Date of publication and mention of the grant of the patent: **08.06.2022**
(21) Application number: 17883762.1
(22) Date of filing: 23.05.2017
(51) Int. Cl.: C23C 14/56, C23C 14/24, B01D 45/16, B04C 5/13

(54) **FILTER UNIT AND PLATING APPARATUS INCLUDING SAME**
FILTEREINHEIT UND PLATTIERUNGSVORRICHTUNG DAMIT
UNITÉ DE FILTRATION ET APPAREIL DE PLACAGE LA COMPRENANT

(30) Priority: 21.12.2016 KR 20160175735
(43) Date of publication of application: 30.10.2019
(73) Proprietor: Posco, Pohang-si, Gyeongsangbuk-do 37859 (KR)
(72) Inventor: NAM, Kyung-Hoon, Gwangyang-si Jeollanam-do 57807 (KR); KIM, Sang-Joon, Pohang-si Gyeongsangbuk-do 37664 (KR); KO, Kyoung-Pil, Gwangyang-si Jeollanam-do 57807 (KR); KIM, Tae-Yeob, Gwangyang-si Jeollanam-do 57807 (KR); EOM, Mun-Jong, Gwangyang-si Jeollanam-do 57807 (KR)
(74) Representative: Zech, Stefan Markus
(86) International application number: PCT/KR2017/005327
(87) International publication number: WO 2018/117348

(56) References cited:
- WO-A1-2007/093123
- WO-A1-2016/114580
- JP-A- H05 208 164
- JP-A- H08 323 249
- JP-A- 2004 148 164
- KR-A- 20040 031 700
- KR-B1- 0 161 204
- US-A1- 2013 061 759

## Description

### [Technical Field]

The present disclosure relates to a filter unit and a plating apparatus including the same.

### [Background Art]

It should be noted that the contents described in this section merely provide background information on the present disclosure and do not constitute the prior art disclosed.

Vacuum deposition is a technique in which a solid coating material is heated and evaporated to be converted into vapor by various methods under a vacuum atmosphere. In this case, the vapor is sprayed and deposited onto a plated body such as a steel sheet, to form a thin film. Coating methods are classified mainly depending on heating methods.

Typical vacuum deposition methods include thermal evaporation, electron beam evaporation, and electromagnetic levitation evaporation.

The coating rate in such a vacuum deposition process is determined by the vapor pressure of a coating material and the heating temperature. The vapor pressure is inherent to the material, and thus may not be controlled arbitrarily, and therefore, a heating temperature of the coating material should be increased to increase the coating rate.

To increase the heating temperature of a coating material, the electric power of a resistance heating heater, the electron beam or an electromagnetic coil should be raised. As a result, as the temperature of a coating material and a crucible rises, the coating material contained in the crucible in the form of molten metal evaporates and boils simultaneously.

When boiling occurs in the molten metal, the surface of the molten metal may become unstable due to bubbles. As the bubbles burst, lumps of the coating material may be released to form a coating on the surface of the specimen, known as coarse particles or splash, as a main cause of deterioration of a coating surface.

For example, for high-speed coating, the coating material should be heated to a high temperature, but coarse particles are released due to the boiling of molten metal, which deteriorates the quality of the coating surface, resulting in a limitation in the high-speed coating.

As an example of a technology for separating and removing such coarse particles, there is a technique of mounting a filter unit between a vapor generating unit and a vapor jetting port.

For example, only the plating vapor is discharged and supplied through the vapor jetting port by the difference in specific gravity between coarse particles and plating vapor.

However, when the plating vapor is discharged from the inside of the filter unit, the plating vapor may still be rotating, resulting in a difference in the plating vapor density.

Accordingly, when the plating vapor discharged from the filter unit is sprayed onto a plated body such as a steel sheet, there may be a problem in which coating uniformity is lowered.

Therefore, to prevent the above-mentioned problems, research into a filter unit and a plating apparatus including the filter unit has been required.

WO2016114580 discloses a dust filter for a vacuum cleaner. A cyclone member receives the incoming air. The air is given a rotational movement and is discharged at the upper part. The dust is collected at the bottom of the filter. The bottom part has wings to reduce the rotational movement of the air flow.

US2013061759 discloses a thin film coating apparatus where precursor gas is formed by bubbling and the gas flow is cleaned from aerosols by a cyclone separator.

### [Disclosure]

### [Technical Problem]

An aspect of the present disclosure is to provide a filter unit capable of supplying plating vapor at a uniform density by reducing a rotational flow of plating vapor while supplying plating vapor from which coarse particles are separated, and a plating apparatus including the same.

### [Technical Solution]

According to an aspect of the present disclosure, a filter unit includes a cyclone body member receiving a fluid introduced thereinto in one direction and having an internal circular cross section, to form a rotational flow of the fluid, and a discharge member disposed on a central upper end portion of the cyclone body member and having at least a portion of which a cross section has a noncircular shape, to reduce the rotational flow of the fluid and then discharge the fluid.

The discharge member of the filter unit has a lower end coupled to the cyclone body member, the lower end having a circular cross section, and an upper end through which the fluid is discharged, the upper end having a non-circular cross section.

The upper end of the discharge member, through which the fluid is discharged, has an elliptical cross section.

According to an aspect of the present disclosure, the discharge member of the filter unit has a cylindrical shape of which a cross section has an elliptical shape.

The elliptical shape of the cross section of the discharge member may have a minor axis length of 0.2 to 0.8 times a major axis length.

According to an aspect of the present disclosure, the discharge member of the filter unit includes a hose portion provided on the central upper end portion of the cyclone body member, having a circular cross section, and formed of a flexible material, and a clamping portion provided in contact with an outer surface of the hose portion and pressing a portion of the hose portion in such a manner that at least a portion of the hose portion has a non-circular cross section.

The clamping portion of the filter unit may include a coupling shaft coupled to the cyclone body member and disposed to be parallel to the hose portion, one pair of swing fingers having one end pin-coupled to the coupling shaft and provided on both sides of the outer surface of the hose portion, and a driving motor fixed to the cyclone body member and threadedly engaged with a thread groove of the other end of the pair of swing fingers having threads formed in different directions.

The pair of swing fingers may have a curved central portion contacting the hose portion.

According to another aspect of the present disclosure, a plating apparatus includes the filter unit, a crucible unit connected to the filter unit and supplying plating vapor as a fluid to the filter unit, and a nozzle unit connected to a discharge member of the filter unit and spraying plating vapor discharged from the filter unit onto a steel sheet.

### [Advantageous Effects]

According to an embodiment in the present disclosure, a filter unit and a plating apparatus including the filter unit may have the effect of supplying plating vapor at a uniform density by reducing a rotational flow of plating vapor while supplying the plating vapor from which coarse particles are separated.

As a result, coarse particles may be removed, and plating vapor may be sprayed onto a steel sheet with a uniform distribution, and thus, a coated steel sheet having excellent coating uniformity may be produced.

It should be understood, however, that the various and advantageous advantages and effects of the present disclosure are not limited to those described above, and may be more readily understood in the course of describing a specific embodiment of the present disclosure.

### [Description of Drawings]

FIG. 1 is a perspective view illustrating a plating apparatus according to an embodiment in the present disclosure.
FIGS. 2 and 3 are perspective views illustrating a discharge member in a filter unit according to an embodiment in the present disclosure.
FIGS. 4A and 4B are plan views illustrating an embodiment in which a discharge member includes a hose portion and a clamping portion in a filter unit according to an embodiment.
FIG. 5 is a side view illustrating an embodiment in which a discharge member includes a hose portion and a clamping portion in a filter unit according to an embodiment.
FIG. 6 is a graph comparing the uniform density effect of plating vapor discharged from a filter unit according to an embodiment in the present disclosure.

### [Best Mode for Invention]

Hereinafter, specific embodiments of the present disclosure will be described in detail with reference to the drawings. It will be apparent to those skilled in the art that various modifications and variations may be made in the present disclosure without departing from the spirit or scope of the present disclosure. Other embodiments within the scope of the present disclosure may readily be suggested, but are also considered to be within the scope of the present disclosure.

The same reference numerals are used to designate the same components having the same function within the scope of the present disclosure in the drawings of the respective embodiments.

A filter unit 100 according to an embodiment in the present disclosure and a plating apparatus including the same are based on the assumption that coarse particles generated during a process of heating a metallic solid or liquid plating material for high-speed plating or the like are separated by the centrifugal force due to rotation of a fluid.

In addition, the filter unit 100 according to an embodiment in the present disclosure and the plating apparatus including the same may alleviate unevenness of plating vapor density, which may occur in a case in which plating vapor from which coarse particles are separated maintains a rotational flow, to supply the plating vapor at a uniform density.

As a result, the coarse particles are removed, and the plating vapor may be sprayed onto a steel sheet S with a uniform distribution, thereby producing a coated steel sheet S having excellent coating uniformity.

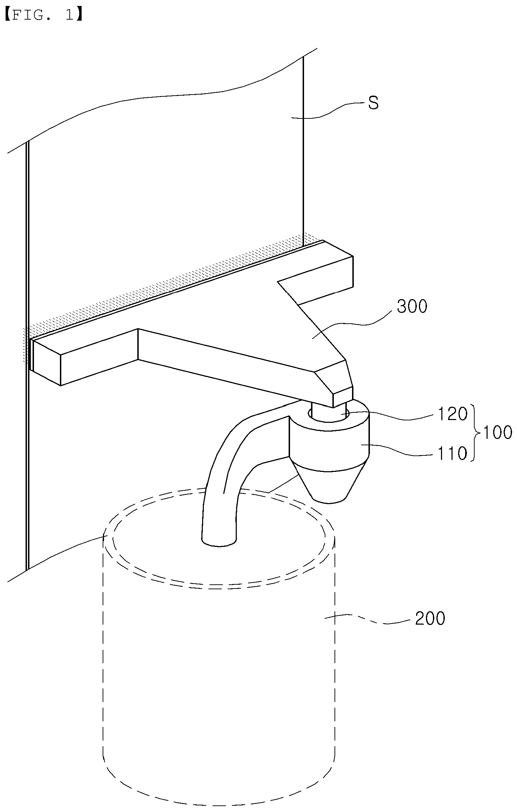

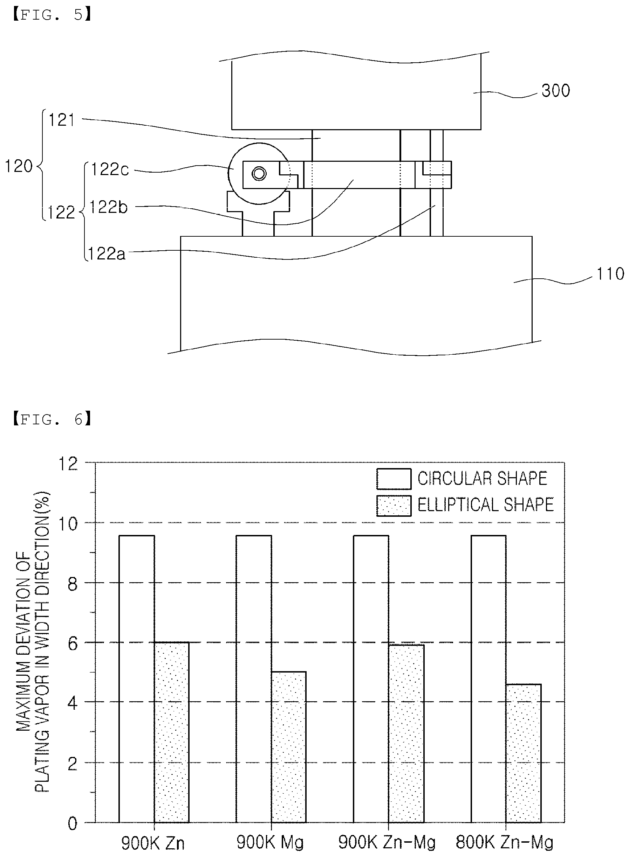

In detail, FIG. 1 is a perspective view illustrating a plating apparatus according to an embodiment in the present disclosure, and FIG. 6 is a graph illustrating a comparison of uniform density effects of plating vapor discharged from the filter unit 100 according to an embodiment.

Referring to FIGS. 1 and 6, a plating apparatus according to another embodiment in the present disclosure includes a filter unit 100, a crucible unit 200 connected to the filter unit 100 to supply, plating vapor, a fluid, to the filter unit 100, and a nozzle unit 300 connected to a discharge member 120 of the filter unit 100 and spraying the plating vapor discharged from the filter unit 100 onto the steel sheet S.

The crucible unit 200 serves to form a plating vapor for plating the steel sheet S.

To this end, the crucible unit 200 is provided with a metallic solid or liquid plating material therein, and is provided with a heating unit to heat the plating material. In this case, the heating unit may be a resistance heating heater, an electron beam, or a field division applying electric power to the electron beam or the electromagnetic coil, but an embodiment thereof is not limited thereto. A heating unit provided in the crucible unit 200 according to an embodiment may be used as long as it may heat the plating material to form plating vapor.

The crucible unit 200 supplies plating vapor to the nozzle unit 300 via the filter unit 100 to spray the plating vapor onto a plated body such as the steel sheet S or the like.

When the nozzle unit 300 receives the plating vapor from the crucible unit 200 via the filter unit 100, the nozzle unit 300 sprays the plating vapor onto the plated body such as the steel sheet S or the like.

In detail, since the nozzle unit 300 receives the plating vapor from the crucible unit 200 through the filter unit 100, the nozzle unit 300 receives the plating vapor, from which coarse particles have been removed, at a uniform density.

Accordingly, the nozzle unit 300 may spray the plating vapor onto the steel sheet S at a uniform density, thereby increasing coating uniformity with respect to the steel sheet S.

This effect may be confirmed in the graph of FIG. 6. For example, FIG. 6 illustrates comparison between a case in which plating vapor is received via filter unit 100 using a circular discharge pipe of the related art and a case in which the plating vapor is received via the filter unit 100 using the elliptical discharge member 120 as in an embodiment of the present disclosure.

In this case, as the plating metal, 900K of zinc (Zn), 900K of magnesium (Mg), 900K of zinc-magnesium mixed metal (Zn-Mg), and 800K of zinc-magnesium mixed metal (Zn-Mg) were used.

The uniformity density of plating vapor in the plating vapor spraying effect was determined using a deviation value, the deviation value being obtained by subtracting a minimum thickness from a maximum thickness of a plating layer on the steel sheet S sprayed with the plating vapor and then dividing the obtained value by an average value. As the steel sheet S, a steel sheet having a width of about 1600 mm was used.

In the results of the experiment conducted under these conditions, it can be seen that a maximum deviation of the plating vapor in a width direction of the steel sheet S in the plating apparatus according to an embodiment in the present disclosure, using the discharge member 120 having an elliptical shape, was reduced substantially about 1/3 to 1/2, as compared with that of the related art technique using a circular discharge pipe.

The filter unit 100 serves to discharge a fluid at a uniform density while separating coarse particles from the fluid such as the plating vapor. To this end, the filter unit 100 may include a cyclone body member 110 and a discharge member 120.

For example, the filter unit 100 according to an embodiment in the present disclosure includes the cyclone body member 110 having a circular cross section with a fluid flowing thereinto in one direction and forming a rotational flow of the fluid, and the discharge member 120 provided on a central upper end portion of the cyclone body member 110 and having at least a portion thereof having a non-circular cross section to reduce rotational flow of the plating vapor to discharge the fluid.

In this case, the cyclone body member 110 induces a centrifugal force on the fluid to separate coarse particles or the like mixed in the fluid therefrom by a specific gravity difference, and the discharge member 120 discharges only the fluid from which the coarse particles have been separated, with reducing the rotational flow of the fluid, and thus, the fluid may be discharged at a uniform density in a cross section of the discharge member in which the fluid is discharged.

The cyclone body member 110 serves to change, a flow of the fluid such as the plating vapor and the like introduced thereinto, into a rotating flow, thereby separating coarse particles by a centrifugal force.

To this end, the cyclone body member 110 may be configured in such a manner that the fluid flows in one direction and the cross sectional shape of the cyclone body member 110 is circular.

When the fluid is introduced into the cyclone body member 110 in one direction thereof, the fluid moves along an inner wall of the cyclone body member 110 and the flow thereof is changed into a rotational flow. Accordingly, coarse particles having a relatively large specific gravity are pushed outward by the centrifugal force imparted to the fluid, and only fluids such as plating vapor having a relatively small specific gravity are gathered on a central portion of the cyclone body member 110.

In this case, the coarse particles pushed outward are slowed down by the friction with the inner wall of the cyclone body member 110, and thus, the coarse particles are gathered on a lower portion of the cyclone body member 110 by gravity to be separated from the plating vapor.

On the other hand, the plating vapor does not slow down and also rotates to generate lift, and thus, is raised in a direction opposite to gravity to be discharged upwardly of the cyclone body member 110 as opposed to the coarse particles.

Only the fluid such as plating vapor gathered on the central portion through the discharge member 120 provided on the central upper end portion of the cyclone body member 110 is transferred to an external configuration such as the nozzle unit 300 or the like.

The discharge member 120 only discharges the fluid such as plating vapor separated from the coarse particles in the cyclone body member 110 externally.

To this end, the discharge member 120 is provided on a central upper end portion of the cyclone body member 110 to discharge only fluid such as plating vapor concentrated on the central portion of the cyclone body member 110 externally.

In detail, the discharge member 120 has a non-circular shape in cross section, not a circular cross section, thereby reducing the rotational flow of the fluid such as the plating vapor or the like.

Thus, on the basis of the discharge cross section of the discharge member 120 through the fluid is discharged, unevenness in the density of the discharged fluid when the fluid such as the plating vapor is maintained in the rotating flow may be prevented.

In a case in which the fluid is maintained in the rotating flow, the density of the fluid is concentrated on a peripheral portion of the discharge cross section rather than on a central portion of the discharge cross section, while a central portion of the discharge cross section has a relatively low density, thereby causing unevenness in fluid density.

Meanwhile, according to an embodiment in the present disclosure, the discharge member 120 may be formed to have a non-circular discharge cross section to reduce the rotational flow of the fluid, thereby reducing the fluid density imbalance in the discharge cross section.

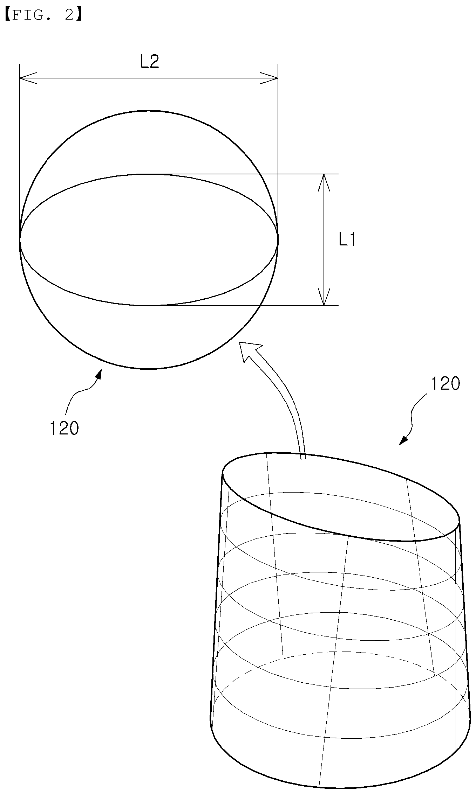

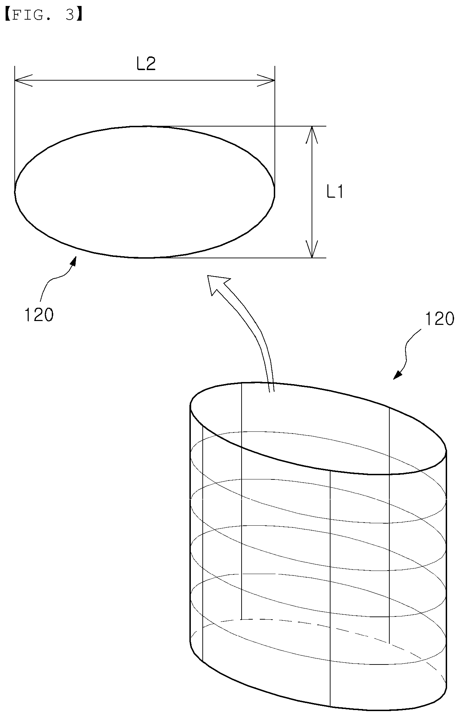

In this case, the non-circular shape may be a polygonal shape such as a quadrangular shape, a triangular shape or the like, but an elliptical shape may be preferable to significantly prevent plating vapor aggregation by vortex generation. A detailed description thereof will be described later with reference to FIGS. 2 or 3.

FIG. 2 is a perspective view illustrating the discharge member 120 in the filter unit 100 according to an embodiment in the present disclosure, in which only an upper end of the discharge member 120 is elliptical.

Referring to FIG. 2, the discharge member 120 of the filter unit 100 according to an embodiment in the present disclosure has a lower end portion, coupled with the cyclone body member 110, and having a circular cross section, and has an upper end portion through which the fluid is discharged and which has a non-circular cross section.

As described above, the discharge member 120 according to an embodiment in the present disclosure has an upper noncircular cross section, through which the fluid is discharged, to reduce a rotational flow of the fluid to reduce the fluid density imbalance.

In detail, the discharge member 120 has a lower end portion formed to have a circular cross section, and an upper end portion, through which the fluid is discharged, formed to have a non-circular cross section, thereby reducing a gradual rotational flow.

As a result, a sudden vortex of the fluid or stagnation of discharged fluid due to sudden reduction of rotational flow may be prevented, thereby preventing agglomeration of plating vapor or the like.

In this case, the non-circular shape may be a polygonal shape such as a quadrangular shape, a triangular shape or the like, but an elliptical shape may be preferable to significantly prevent plating vapor cohesion by vortex generation.

For example, in the case of the discharge member 120 of the filter unit 100 according to an embodiment of the present disclosure, the upper end thereof through which the fluid is discharged may have an elliptical cross section.

In this case, if the upper end of the discharge member 120 is angular, the flow is stagnated at angled portions, and a relatively rapid flow is formed on a flat portion between the angled portions. Thus, in this case, since there is a problem of occurrence of vortex due to a flow difference, an upper end of the discharge member 120 may be formed to have an elliptical shape.

FIG. 3 is a perspective view illustrating the discharge member 120 in the filter unit 100 according to an embodiment in the present disclosure, and illustrating an embodiment in which the discharge member 120 is configured to have an elliptical cylinder shape.

Referring to FIG. 3, the discharge member 120 of the filter unit 100 according to an embodiment of the present disclosure may have a cylindrical shape having an elliptical cross section.

In this case, when the rotational flow of the fluid is reduced, the rotational flow of fluid may be stably removed from the fluid discharged to the upper end of the discharge member 120, as a result of ensuring a period of time (or distance) in which the fluid may be adapted for rotational flow reduction.

In this case, a cross sectional ellipse of the discharge member 120 of the filter unit 100 according to an embodiment in the present disclosure has a minor axis (L1) length of 0.2 to 0.8 times a major axis (L2) length.

In this case, with respect to an upper limit value and a lower limit value in a numerical range, if exceeding the upper limit, since the effect of reducing the rotational flow is immaterial as compared with the case of the circular cross section, there is no meaning of the elliptical limitation. Further, in the case of less than the lower limit value, since the reduction of the rotational flow is suddenly generated, a problem of agglomeration of the plating vapor or the like may occur.

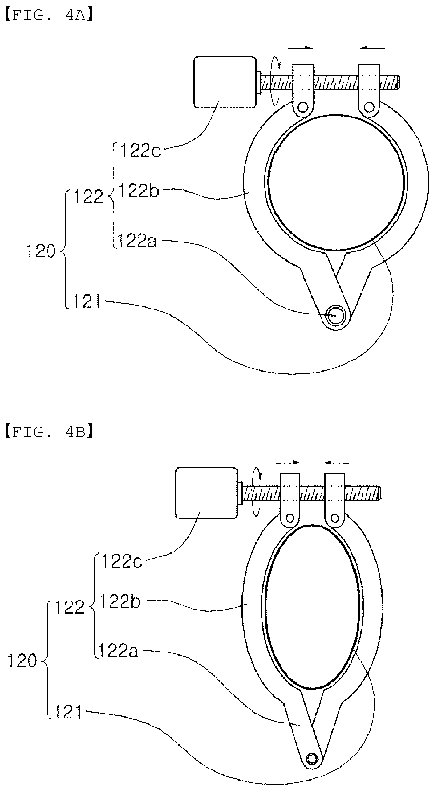

FIGS. 4A and 4B are plan views illustrating an embodiment in which the discharge member 120 in the filter unit 100 according to an embodiment in the present disclosure includes a hose portion 121 and a clamping portion 122. FIG. 5 is a side view illustrating an embodiment in which the discharge member 120 in the filter unit 100 according to an embodiment in the present disclosure includes a hose portion 121 and a clamping portion 122.

Referring to FIGS. 4A to 5, the discharge member 120 of the filter unit 100 according to an embodiment in the present disclosure may include the hose portion 121 provided on a central upper end portion of the cyclone body member 110, having a circular cross section and formed of a flexible material; and the clamping portion 122 provided in contact with an outer surface of the hose portion 121 and pressing a portion of the hose portion 121 to ensure at least a portion of the hose portion 121 to have a non-circular cross section.

As described above, in order for the discharge member to have a non-circular cross section, the discharge member 120 includes the hose portion 121 and the clamping portion 122.

Although the embodiment, in which the discharge member 120 includes the hose portion 121 and the clamping portion 122 to have the non-circular cross section, is provided by way of an example, the discharge member 120 may also be formed of a rigid body that is formed to have a non-circular cross section with a shape not deformed.

The hose portion 121 serves to connect the cyclone body member 110 to an external nozzle unit 300 or the like.

In detail, in the case of the hose portion 121, when the clamping portion 122 presses an outer surface of the hose portion 121, the hose portion is formed to have a non-circular cross section, such that a rotational flow rate of the fluid such as plating vapor introduced from the cyclone body member 110 is reduced and thus, the plating vapor may have a transformed shape.

To this end, the hose portion 121 may be formed of a flexible material. As an example, a rubber material may be used, and a metal material or a plastic material of which rigidity is lowered at a high temperature may be used. Alternatively, an inner side of the hose portion may be formed of a ceramic material which is resistant to high temperature, and an outer side thereof may be formed of a woolen material inducing shape deformation.

The clamping portion 122 press the hose portion 121 to serve the hose portion 121 to be formed to have a non-circular cross section. To this end, the clamping portion 122 may include a coupling shaft 122a, a swing finger 122b, and a driving motor 122c.

For example, the clamping portion 122 of the filter unit 100 according to an embodiment in the present disclosure includes the coupling shaft 122a coupled to the cyclone body member 110 and disposed to be parallel to the hose portion 121, one pair of swing fingers 122b having one end pin-coupled to the coupling shaft 122a and provided on both sides of the outer surface of the hose portion 121, and a driving motor 122c fixed to the cyclone body member 110 and threadedly engaged with a thread groove of the other end of the swing finger 122b having threads formed in different directions.

As described above, the swing fingers 122b are provided adjacent to the outer surface of the hose portion 121 as a pair, and are swingable about the coupling shaft 122a.

When the driving motor 122c rotates in the forward direction, the swing fingers 122b moves to be close to each other, and when the driving motor 122c rotates in a reverse direction, the swing fingers 122b move away from each other.

In this case, when the swing fingers 122b is operated to be tightened, the swing fingers 122b press the outer surface of the hose portion 121, such that the hose portion may have a non-circular cross section.

In detail, when the swing fingers 122b have a curved shape that is to be in contact with the hose portion 121, the cross section of the hose portion 121 pressed by the swing fingers 122b is deformed from a circular shape to an elliptical shape.

For example, the swing fingers 122b of the filter unit 100 according to an embodiment in the present disclosure have a curved surface on a central portion thereof contacting the hose portion 121.

In this case, to form an elliptical cross section of the pressed portion of the hose portion 121, in more detail, when a pair of the swing fingers 122b are in close contact with each other, a central portion of one pair of swing fingers may have a curved surface such that an elliptical hole may be formed in a central portion of the hose portion.

## Claims

1. A filter unit (100) comprising:
a cyclone body member (110) receiving a fluid introduced thereinto in one direction and having an internal circular cross section, to form a rotational flow of the fluid;
and
a discharge member (120) disposed on a central upper end portion of the cyclone body member (110) and having at least a portion of which a cross section has a noncircular shape, to reduce the rotational flow of the fluid and then discharge the fluid,
wherein the discharge member (120) has a lower end coupled to the cyclone body member (110) and an upper end through which the fluid is discharged,
wherein the lower end of the discharge member (120) has a circular cross section, and the upper end of the discharge member has an elliptical cross section.

2. A filter unit (100) comprising:
a cyclone body member (110) receiving a fluid introduced thereinto in one direction and having an internal circular cross section, to form a rotational flow of the fluid; and
a discharge member (120) disposed on a central upper end portion of the cyclone body member (110) and having at least a portion of which a cross section has a noncircular shape, to reduce the rotational flow of the fluid and then discharge the fluid,
wherein the discharge member (120) has a cylindrical shape of which a cross section has an elliptical shape.

3. The filter unit (100) of claim 2, wherein the elliptical shape of the cross section of the discharge member (120) has a minor axis length of 0.2 to 0.8 times a major axis length.

4. A filter unit (100) comprising:
a cyclone body member (110) receiving a fluid introduced thereinto in one direction and having an internal circular cross section, to form a rotational flow of the fluid; and
a discharge member (120) disposed on a central upper end portion of the cyclone body member (110) and having at least a portion of which a cross section has a noncircular shape, to reduce the rotational flow of the fluid and then discharge the fluid,
wherein the discharge member (120) comprises:
a hose portion (121) having a circular cross section provided on the central upper end portion of the cyclone body member (110), wherein the hose portion (121) is formed of a flexible material; and
a clamping portion (122) provided in contact with an outer surface of the hose portion (121) and pressing a portion of the hose portion (121) in such a manner that at least a portion of the hose portion (121) has a non-circular cross section.

5. The filter unit (100) of claim 4, wherein the clamping portion (122) comprises:
a coupling shaft (122a) coupled to the cyclone body member (110) and disposed to be parallel to the hose portion (121);
one pair of swing fingers (122b) having one end pin-coupled to the coupling shaft (122a) and provided on both sides of the outer surface of the hose portion (121); and
a driving motor (122c) fixed to the cyclone body member (110) and threadedly engaged with a thread groove of the other end of the pair of swing fingers (122b) having threads formed in different directions.

6. The filter unit (100) of claim 5, wherein the pair of swing fingers (122b) have a curved central portion contacting the hose portion (121).

7. A plating apparatus comprising:
the filter unit (100) of any one of claims 1 to 6;
a crucible unit (200) connected to the filter unit (100) and supplying plating vapor as a fluid to the filter unit (100); and
a nozzle unit (300) connected to the discharge member (120) of the filter unit (100) and spraying plating vapor discharged from the filter unit (100) to a steel sheet (S).

## Patentansprüche

1. Filtereinheit (100), umfassend:
ein Zyklonkörperelement (110), das ein in einer Richtung darin eingeleitetes Fluid aufnimmt und einen inneren kreisförmigen Querschnitt aufweist, um eine Rotationsströmung des Fluids zu bilden;
und
ein Austragselement (120), das an einem mittigen oberen Endabschnitt des Zyklonkörperelements (110) angeordnet ist und wenigstens einen Abschnitt aufweist, dessen Querschnitt eine nicht kreisförmige Form aufweist, um die Rotationsströmung des Fluids zu verringern und das Fluid anschließend auszutragen,
wobei das Austragselement (120) ein unteres Ende, das mit dem Zyklonkörperelement (110) gekoppelt ist, und ein oberes Ende, durch das das Fluid ausgetragen wird, aufweist,
wobei das untere Ende des Austragselements (120) einen kreisförmigen Querschnitt aufweist und das obere Ende des Austragselements einen elliptischen Querschnitt aufweist.

2. Filtereinheit (100), umfassend:
ein Zyklonkörperelement (110), das ein in einer Richtung darin eingeleitetes Fluid aufnimmt und einen inneren kreisförmigen Querschnitt aufweist, um eine Rotationsströmung des Fluids zu bilden; und
ein Austragselement (120), das an einem mittigen oberen Endabschnitt des Zyklonkörperelements (110) angeordnet ist und wenigstens einen Abschnitt aufweist, dessen Querschnitt eine nicht kreisförmige Form aufweist, um die Rotationsströmung des Fluids zu verringern und das Fluid anschließend auszutragen,
wobei das Austragselement (120) eine zylindrische Form aufweist, deren Querschnitt eine elliptische Form aufweist.

3. Filtereinheit (100) nach Anspruch 2, wobei die elliptische Form des Querschnitts des Austragselements (120) eine Nebenachsenlänge mit dem 0,2- bis 0,8-Fachen einer Hauptachsenlänge aufweist.

4. Filtereinheit (100), umfassend:
ein Zyklonkörperelement (110), das ein in einer Richtung darin eingeleitetes Fluid aufnimmt und einen inneren kreisförmigen Querschnitt aufweist, um eine Rotationsströmung des Fluids zu bilden; und
ein Austragselement (120), das an einem mittigen oberen Endabschnitt des Zyklonkörperelements (110) angeordnet ist und wenigstens einen Abschnitt aufweist, dessen Querschnitt eine nicht kreisförmige Form aufweist, um die Rotationsströmung des Fluids zu verringern und das Fluid anschließend auszutragen,
wobei das Austragselement (120) Folgendes umfasst:
einen Schlauchabschnitt (121) mit einem kreisförmigen Querschnitt, der an dem mittigen oberen Endabschnitt des Zyklonkörperelements (110) vorgesehen ist, wobei der Schlauchabschnitt (121) aus einem biegsamen Material gebildet ist; und
einen Klemmabschnitt (122), der in Kontakt mit einer Außenfläche des Schlauchabschnitts (121) vorgesehen ist und einen Abschnitt des Schlauchabschnitts (121) so drückt, dass wenigstens ein Abschnitt des Schlauchabschnitts (121) einen nicht kreisförmigen Querschnitt aufweist.

5. Filtereinheit (100) nach Anspruch 4, wobei der Klemmabschnitt (122) Folgendes umfasst:
eine Kopplungswelle (122a), die mit dem Zyklonkörperelement (110) gekoppelt ist und so angeordnet ist, dass sie parallel zu dem Schlauchabschnitt (121) verläuft;
ein Paar von Schwenkfingern (122b), deren eines Ende mit der Kupplungswelle (122a) stiftgekoppelt ist und die auf beiden Seiten der Außenfläche des Schlauchabschnitts (121) vorgesehen sind; und
einen Antriebsmotor (122c), der an dem Zyklonkörperelement (110) befestigt ist und in Gewindeeingriff mit einer Gewindenut des anderen Endes des Paares von Schwenkfingern (122b) steht, die Gewinde aufweisen, die in unterschiedlichen Richtungen ausgebildet sind.

6. Filtereinheit (100) nach Anspruch 5, wobei das Paar von Schwenkfingern (122b) einen gekrümmten Mittelabschnitt aufweist, der den Schlauchabschnitt (121) berührt.

7. Plattiervorrichtung, umfassend:
die Filtereinheit (100) nach einem der Ansprüche 1 bis 6;
eine Tiegeleinheit (200), die mit der Filtereinheit (100) verbunden ist und der Filtereinheit (100) Plattierungsdampf als Fluid zuführt; und
eine Düseneinheit (300), die mit dem Austragselement (120) der Filtereinheit (100) verbunden ist und den aus der Filtereinheit (100) ausgetragenen Plattierungsdampf auf ein Stahlblech (S) sprüht.

## Revendications

1. Unité de filtre (100) comprenant :
un organe de corps de cyclone (110) recevant un fluide introduit dans celui-ci dans une direction et ayant une section circulaire interne, pour former un flux de rotation du fluide ;
et
un organe d'évacuation (120) disposé sur une portion d'extrémité supérieure centrale de l'organe de corps de cyclone (110) et ayant au moins une portion dont une section a une forme non circulaire, pour réduire le flux de rotation du fluide puis évacuer le fluide,
dans laquelle l'organe d'évacuation (120) a une extrémité inférieure couplée à l'organe de corps de cyclone (110) et une extrémité supérieure à travers laquelle le fluide est évacué,
dans laquelle l'extrémité inférieure de l'organe d'évacuation (120) a une section circulaire, et l'extrémité supérieure de l'organe d'évacuation a une section elliptique.

2. Unité de filtre (100) comprenant :
un organe de corps de cyclone (110) recevant un fluide introduit dans celui-ci dans une direction et ayant une section circulaire interne, pour former un flux de rotation du fluide ; et
un organe d'évacuation (120) disposé sur une portion d'extrémité supérieure centrale de l'organe de corps de cyclone (110) et ayant au moins une portion dont une section à une forme non circulaire, pour réduire le flux de rotation du fluide puis évacuer le fluide,
dans laquelle l'organe d'évacuation (120) a une forme cylindrique dont une section a une forme elliptique.

3. Unité de filtre (100) selon la revendication 2, dans laquelle la forme elliptique de la section de l'organe d'évacuation (120) a une longueur de petit axe de 0,2 à 0,8 fois une longueur de grand axe.

4. Unité de filtre (100) comprenant :
un organe de corps de cyclone (110) recevant un fluide introduit dans celui-ci dans une direction et ayant une section circulaire interne, pour former un flux de rotation du fluide ; et
un organe d'évacuation (120) disposé sur une portion d'extrémité supérieure centrale de l'organe de corps de cyclone (110) et ayant au moins une portion dont une section a une forme non circulaire, pour réduire le flux de rotation du fluide puis évacuer le fluide,
dans laquelle l'organe d'évacuation (120) comprend :
une portion de tuyau (121) ayant une section circulaire prévue sur la portion d'extrémité supérieure centrale de l'organe de corps de cyclone (110), dans laquelle la portion de tuyau (121) est formée d'un matériau flexible ; et
une portion de serrage (122) prévue en contact avec une surface extérieure de la portion de tuyau (121) et appuyant sur une portion de la portion de tuyau (121) de manière à ce qu'au moins une portion de la portion de tuyau (121) ait une section non circulaire.

5. Unité de filtre (100) selon la revendication 4, dans laquelle la portion de serrage (122) comprend :
un arbre de couplage (122a) couplé à l'organe de corps de cyclone (110) et disposé pour être parallèle à la portion de tuyau (121) ;
une paire de doigts oscillants (122b) ayant une broche d'extrémité couplée à l'arbre de couplage (122a) et prévus sur les deux côtés de la surface extérieure de la portion de tuyau (121) ; et
un moteur d'entraînement (122c) fixé à l'organe de corps de cyclone (110) et engagé par filetage avec une rainure filetée de l'autre extrémité de la paire de doigts oscillants (122b) ayant des filets formés dans des directions différentes.

6. Unité de filtre (100) selon la revendication 5, dans laquelle la paire de doigts oscillants (122b) ont une portion centrale courbée entrant en contact avec la portion de tuyau (121).

7. Appareil de placage comprenant :
l'unité de filtre (100) de l'une quelconque des revendications 1 à 6 ;
une unité de creuset (200) raccordée à l'unité de filtre (100) et fournissant de la vapeur de placage sous forme de fluide à l'unité de filtre (100) ; et
une unité de buse (300) raccordée à l'organe d'évacuation (120) de l'unité de filtre (100) et pulvérisant de la vapeur de placage évacuée depuis l'unité de filtre (100) sur une tôle d'acier (S).
